# EUROPEAN PATENT APPLICATION

(11) **EP 4 746 591 A1**
(43) Date of publication of application: **20.05.2026**
(21) Application number: 24847744.0
(22) Date of filing: 31.05.2024
(51) Int. Cl.: H05K 1/14

(54) **ELECTRONIC ASSEMBLY AND ELECTRONIC DEVICE**

(30) Priority: 03.08.2023 CN 202310972699
(71) Applicant: Huawei Technologies Co., Ltd., Shenzhen, Guangdong 518129 (CN)
(72) Inventor: HUANG, Jinhui, Shenzhen, Guangdong 518129 (CN); HE, Dapeng, Shenzhen, Guangdong 518129 (CN); ZHAO, Yanhui, Shenzhen, Guangdong 518129 (CN)
(74) Representative: Goddar, Heinz J.
(86) International application number: PCT/CN2024/096620
(87) International publication number: WO 2025/025781

(57) **Abstract**

Embodiments of this application provide an electronic assembly and an electronic device. The electronic assembly includes a printed circuit board and a flexible printed circuit. A first pad is disposed on a first surface of the printed circuit board, a second pad is disposed on a second surface of the flexible printed circuit, and the first pad is connected to the second pad through soldering, so that a physical connection and a signal connection between the printed circuit board and the flexible printed circuit can be implemented. To improve soldering effect, a support structure is disposed between the printed circuit board and the flexible printed circuit, so that a preset gap exists between the printed circuit board and the flexible printed circuit. The preset gap serves as a gas outlet channel. Gas generated during a soldering process is discharged through the gas outlet channel between the printed circuit board and the flexible printed circuit, so that solder is not displaced, thereby improving reliability of soldering between the first pad and the second pad, and improving efficiency and reliability of signal transmission between the printed circuit board and the flexible printed circuit.

## Description

### CROSS-REFERENCE TO RELATED APPLICATIONS

This application claims priority to Chinese Patent Application No. 202310972699.7, filed with the China National Intellectual Property Administration on August 3, 2023 and entitled "ELECTRONIC ASSEMBLY AND ELECTRONIC DEVICE", which is incorporated herein by reference in its entirety.

### TECHNICAL FIELD

This application relates to the field of electronic device technologies, and in particular, to an electronic assembly and an electronic device.

### BACKGROUND

A flexible printed circuit (flexure circuit board, FPC) has advantages such as high density, lightness, and thinness, and may be soldered to a printed circuit board (printed circuit board, PCB), so that the FPC is connected to the PCB, thereby implementing on-board signal transmission. To ensure reliability of signal transmission between the PCB and the FPC, soldering quality needs to be properly controlled, to implement high-yield and high-quality soldering between the PCB and the FPC.

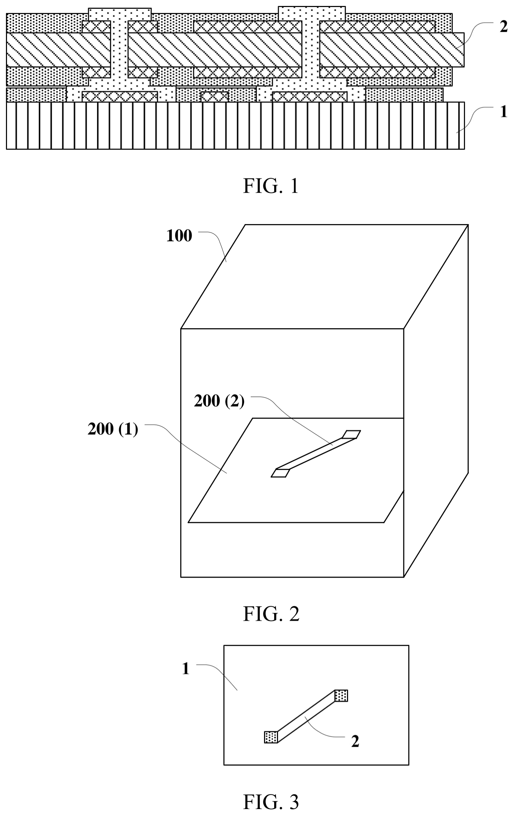

FIG. 1 is a diagram of a cross-sectional structure of an electronic assembly in the conventional technology. As shown in FIG. 1, in the conventional technology, the electronic assembly includes an FPC 1 and a PCB 2 that are connected through soldering. For soldering between the FPC 1 and the PCB 2, a pressure head usually needs to be added on a surface that is of the FPC 1 and that is away from the PCB 2, to ensure that a surface that is of the FPC 1 and that faces the PCB 2 is in contact with a surface that is of the PCB 2 and that faces the FPC 1 during the entire soldering process, thereby facilitating soldering between a pad of the FPC and a pad of the PCB. Gas may be generated during the soldering process, and if the gas displaces molten solder, various defects may occur in a solder joint, resulting in low soldering yield. This leads to poor reliability of signal transmission between the PCB and the FPC.

### SUMMARY

Embodiments of this application provide an electronic assembly and an electronic device, to improve strength of soldering between a printed circuit board and a flexible printed circuit, and improve efficiency and reliability of signal transmission between the printed circuit board and the flexible printed circuit.

According to a first aspect, this application provides an electronic assembly. The electronic assembly includes a printed circuit board and a flexible printed circuit. A first pad is disposed on a first surface of the printed circuit board, a second pad is disposed on a second surface of the flexible printed circuit, and the first pad is connected to the second pad through soldering, so that a physical connection and a signal connection between the printed circuit board and the flexible printed circuit can be implemented. To improve soldering effect, a support structure is disposed between the printed circuit board and the flexible printed circuit, so that a preset gap exists between the printed circuit board and the flexible printed circuit. The preset gap serves as a gas outlet channel. Gas generated during a soldering process is discharged through the gas outlet channel between the printed circuit board and the flexible printed circuit, so that solder is not displaced, thereby improving reliability of soldering between the first pad and the second pad, and improving efficiency and reliability of signal transmission between the printed circuit board and the flexible printed circuit.

Specifically, when the support structure is formed, the support structure may be an integrated structure. The support structure may be fastened to the printed circuit board or the flexible printed circuit. For example, the support structure may be fastened to the first surface of the printed circuit board, and one end that is of the support structure and that is away from the printed circuit board abuts against the second surface of the flexible printed circuit. Alternatively, the support structure may be fastened to the second surface of the flexible printed circuit, and one end that is of the support structure and that is away from the flexible printed circuit abuts against the first surface of the printed circuit board. In this solution, the support structure is simple, and a requirement for precision of position manufacturing and design of the support structure is low.

In another possible technical solution, the support structure is a split structure. For example, the support structure includes two parts. Specifically, the support structure includes a first support structure and a second support structure. The first support structure is fastened to the first surface of the printed circuit board, and the second support structure is fastened to the second surface of the flexible printed circuit. The first support structure and the second support structure abut against each other, and provide support between the flexible printed circuit and the printed circuit board, to form the preset gap. In this solution, the first support structure and the second support structure may be separately manufactured to be short, thereby simplifying a manufacturing process of the support structure.

A plurality of support structures may be disposed between the flexible printed circuit and the printed circuit board, and the plurality of support structures are evenly distributed between the printed circuit board and the flexible printed circuit, to form a uniform gas outlet channel.

In addition, positions of the support structures may alternatively be designed based on actual distribution of solder joints between the flexible printed circuit and the printed circuit board. For example, the support structures are disposed on at least two sides of the first pad. In this solution, the gas outlet channel may be formed in a targeted manner on a periphery of the solder joint between the printed circuit board and the flexible printed circuit, to discharge gas generated by the solder joint.

A specific material for forming the support structure is not limited either. For example, the support structure includes at least one of a copper layer, a solder mask layer, a silkscreen layer, a coverlay, and an adhesive film. For the support structure formed on the surface of the printed circuit board, a material required for manufacturing the printed circuit board is preferentially selected, and for the support structure formed on the surface of the flexible printed circuit, a material required for manufacturing the flexible printed circuit is preferentially selected, to simplify a manufacturing process of the support structure.

In another possible manner of disposing the support structure, the support structure may alternatively be disposed in solder between the first pad and the second pad. In this solution, the support structure does not need to be formed when the printed circuit board or the flexible printed circuit is formed. Instead, the support structure is added during soldering. This simplifies a manufacturing process of the printed circuit board and a manufacturing process of the flexible printed circuit. In addition, the support structure is directly disposed in a solder joint, which is more targeted.

In this solution, the support structure may have a plurality of shapes. For example, the support structure may be a spacer, a ball, or an irregular block.

To ensure that the support structure can be reliably fastened to the solder, at least the surface of the support structure is a metal surface. For example, the support structure may be a metal support structure, which has high support strength. Alternatively, the support structure may have a metal layer on a surface, and a core made of a polymer material is disposed inside the support structure, so that costs are low.

According to a second aspect, this application further provides an electronic device. The electronic device includes a housing and the electronic assembly provided in the first aspect, and the electronic assembly is disposed in the housing. Signal transmission efficiency and reliability of the electronic device are high.

### BRIEF DESCRIPTION OF DRAWINGS

FIG. 1 is a diagram of a cross-sectional structure of an electronic assembly in the conventional technology;
FIG. 2 is a diagram of a structure of an electronic device according to an embodiment of this application;
FIG. 3 is a diagram of a structure of an electronic assembly according to an embodiment of this application;
FIG. 4 is a diagram of another structure of an electronic assembly according to an embodiment of this application;
FIG. 5 is a diagram of another structure of an electronic assembly according to an embodiment of this application;
FIG. 6 is a diagram of another structure of an electronic assembly according to an embodiment of this application;
FIG. 7 is a diagram of another structure of an electronic assembly according to an embodiment of this application;
FIG. 8 is a diagram of another structure of an electronic assembly according to an embodiment of this application;
FIG. 9 is a diagram of another structure of an electronic assembly according to an embodiment of this application;
FIG. 10 is a diagram of another structure of an electronic assembly according to an embodiment of this application;
FIG. 11 is a diagram of a structure of a flexible printed circuit according to an embodiment of this application;
FIG. 12 is a diagram of another structure of a flexible printed circuit according to an embodiment of this application;
FIG. 13 is a diagram of a partial cross-sectional view of a structure of an electronic assembly according to an embodiment of this application;
FIG. 14 is a diagram of a partial cross-sectional view of another structure of an electronic assembly according to an embodiment of this application;
FIG. 15 is a diagram of a partial cross-sectional view of another structure of an electronic assembly according to an embodiment of this application;
FIG. 16 is a diagram of a partial cross-sectional view of another structure of an electronic assembly according to an embodiment of this application;
FIG. 17 is a diagram of a partial cross-sectional view of another structure of an electronic assembly according to an embodiment of this application;
FIG. 18 is a diagram of a partial cross-sectional view of another structure of an electronic assembly according to an embodiment of this application;
FIG. 19 is a diagram of a partial cross-sectional view of another structure of an electronic assembly according to an embodiment of this application; and
FIG. 20 is a diagram of a partial cross-sectional view of another structure of an electronic assembly according to an embodiment of this application.

### Reference numerals:

1: printed circuit board;
11: first surface;
12: first pad;
13: first line;
2: flexible printed circuit;
21: second surface;
22: second pad;
23: second line;
3: connector;
4: package structure;
5: support structure;
51: first support structure;
52: second support structure;
6: preset gap;
100: housing;
200: electronic assembly.

### DESCRIPTION OF EMBODIMENTS

To make objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment" or "a specific embodiment" or the like described in this specification means that one or more embodiments of this application include a specific feature, structure, or characteristic described with reference to embodiments. The terms "include", "comprise", "have", and their variants all mean "include but are not limited to", unless otherwise specifically emphasized in another manner.

To facilitate understanding of an electronic assembly and an electronic device that are provided in embodiments of this application, the following first describes an application scenario of the electronic assembly and the electronic device.

The electronic device in embodiments of this application may be an electronic device like a communications device (for example, a router), a computing device (for example, a server), a network device (for example, a switch), or a storage device (for example, a storage array), or may be an electronic device like an optical module, a vehicle-mounted device, or a terminal device. A specific type of the electronic device is not limited in this application, and the technical solution provided in this application may be used as long as an electronic device includes an electronic assembly in which a flexible printed circuit is connected to a printed circuit board.

For ease of description, in embodiments of this application, an example in which the electronic device is a server is used for description. FIG. 2 is a diagram of a structure of an electronic device according to an embodiment of this application. As shown in FIG. 2, the electronic device may include a housing 100 and an electronic assembly 200 disposed in the housing 100. Specifically, when the electronic device is a cabinet server, the housing 100 may be understood as a cabinet body of the cabinet server, and the electronic assembly 200 may include a node. As shown in FIG. 2, the electronic assembly 200 specifically includes a flexible printed circuit 2 and a printed circuit board 1. The flexible printed circuit 2 is connected to the printed circuit board 1 through soldering, to implement a physical connection and a signal connection between the flexible printed circuit 2 and the printed circuit board 1.

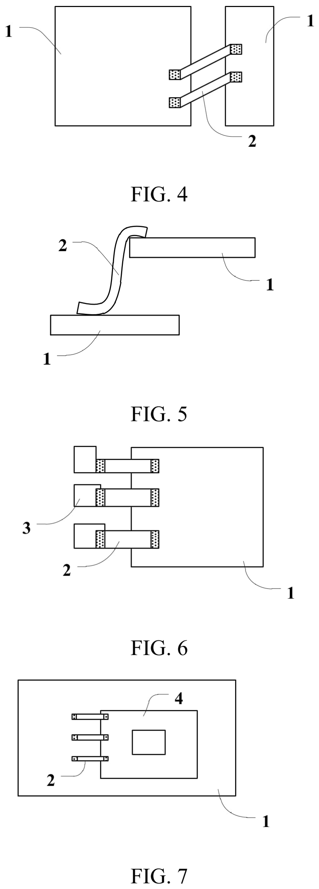

The electronic assembly may be applied to different application scenarios, or the electronic assembly may have different configurations. For example, FIG. 3 is a diagram of a structure of an electronic assembly according to an embodiment of this application. As shown in FIG. 3, in a specific embodiment, the flexible printed circuit 2 in the electronic assembly is configured to implement an on-board jumper for the printed circuit board 1. Specifically, both ends of the flexible printed circuit 2 are soldered to the printed circuit board 1, to implement transmission of signals at two positions in the printed circuit board 1. FIG. 4 is a diagram of another structure of an electronic assembly according to an embodiment of this application. As shown in FIG. 4, in another specific embodiment, the electronic assembly may include two printed circuit boards 1, and the two printed circuit boards 1 are roughly located in a same plane. Two ends of the flexible printed circuit 2 are respectively connected to the two printed circuit boards 1 through soldering, so that the flexible printed circuit 2 is connected between the two printed circuit boards 1, and a signal can be transmitted between the two printed circuit boards 1 via the flexible printed circuit 2, thereby implementing inter-board interconnection. FIG. 5 is a diagram of another structure of an electronic assembly according to an embodiment of this application. As shown in FIG. 5, in another specific embodiment, the electronic assembly may include two printed circuit boards 1, and the two printed circuit boards 1 are located in different planes. Two ends of the flexible printed circuit 2 are respectively connected to the two printed circuit boards 1 through soldering, so that the flexible printed circuit 2 is connected between the two printed circuit boards 1, and a signal can be transmitted between the two printed circuit boards 1 via the flexible printed circuit 2, thereby implementing a cross-board connection. FIG. 6 is a diagram of another structure of an electronic assembly according to an embodiment of this application. As shown in FIG. 6, in another specific embodiment, one end of the flexible printed circuit 2 in the electronic assembly is connected to the printed circuit board 1 through soldering, and the other end is connected to a connector 3, so that transmission can be implemented between the connector 3 and the printed circuit board 1 via the flexible printed circuit 2, and then the printed circuit board 1 may be connected to an external device through the connector 3. The flexible printed circuit 2, the printed circuit board 1, and the connector 3 form an electronic module. FIG. 7 is a diagram of another structure of an electronic assembly according to an embodiment of this application. As shown in FIG. 7, in another specific embodiment, the flexible printed circuit 2 implements a connection between a package structure 4 and the printed circuit board 1, so that a signal can be transmitted between the package structure 4 and the printed circuit board 1. Specifically, one end of the flexible printed circuit 2 is connected to the package structure 4, and the other end of the flexible printed circuit 2 is connected to the printed circuit board 1.

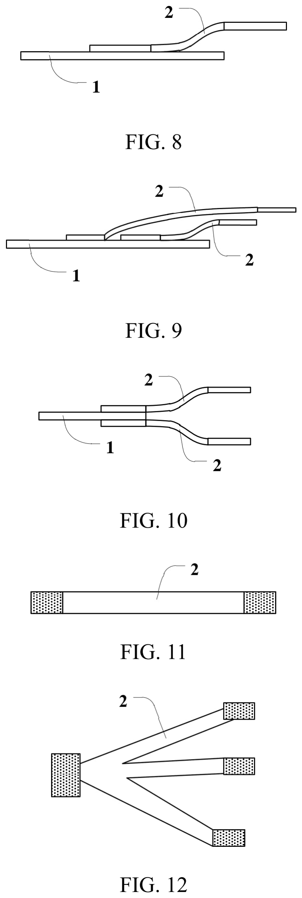

FIG. 8 is a diagram of another structure of an electronic assembly according to an embodiment of this application. As shown in FIG. 8, in another specific embodiment, one flexible printed circuit 2 is soldered on a surface of the printed circuit board 1. FIG. 9 is a diagram of another structure of an electronic assembly according to an embodiment of this application. As shown in FIG. 9, in another specific embodiment, a plurality of flexible printed circuits 2 are soldered on a surface of the printed circuit board 1 in a stacked manner. In addition, the flexible printed circuit 2 may be connected to a single side of the printed circuit board 1, as shown in FIG. 8 and FIG. 9. Alternatively, FIG. 10 is a diagram of another structure of an electronic assembly according to an embodiment of this application. As shown in FIG. 10, in another specific embodiment, the flexible printed circuit 2 may alternatively be connected to both sides of the printed circuit board 1.

A specific form of the flexible printed circuit 2 is not limited in embodiments of this application. FIG. 11 is a diagram of a structure of the flexible printed circuit 2 according to an embodiment of this application. FIG. 12 is a diagram of another structure of the flexible printed circuit 2 according to an embodiment of this application. In a possible embodiment, as shown in FIG. 11, the flexible printed circuit 2 may be a point-to-point flexible printed circuit 2. That is, the flexible printed circuit 2 is configured to implement signal transmission between two points. Specifically, the flexible printed circuit 2 includes two second pads 22, and the two second pads 22 are respectively located at two ends of the flexible printed circuit 2. As shown in FIG. 12, the flexible printed circuit 2 may be a point-to-multipoint flexible printed circuit 2. That is, the flexible printed circuit 2 is configured to implement signal transmission between one point and a plurality of points. Specifically, the flexible printed circuit 2 includes a plurality of second pads 22, one of the second pads 22 is located at one end of the flexible printed circuit 2, and at least two second pads 22 are located at the other end of the flexible printed circuit 2.

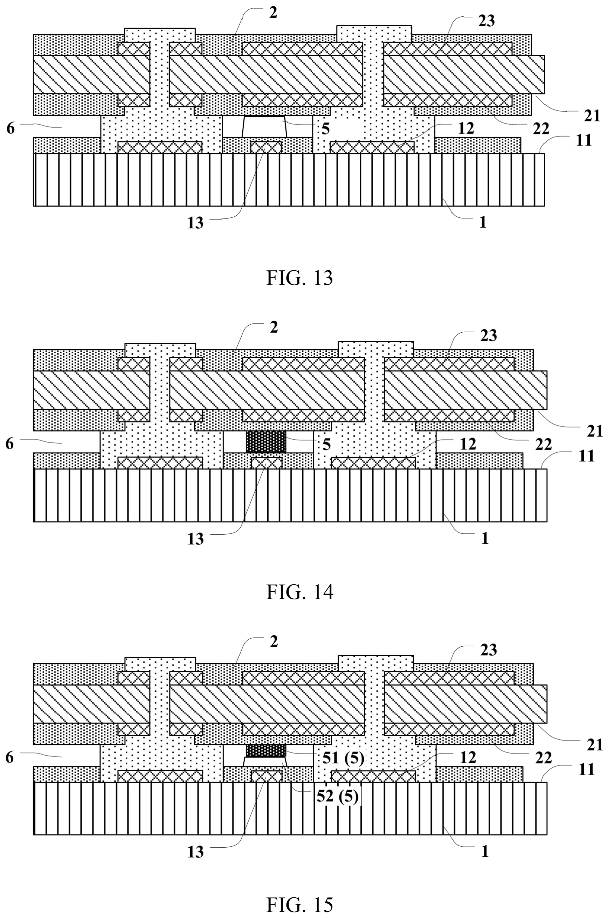

FIG. 13 is a diagram of a partial cross-sectional view of a structure of an electronic assembly according to an embodiment of this application. As shown in FIG. 13, a surface that is of a printed circuit board 1 and that faces a flexible printed circuit 2 is a first surface 11, and a first pad 12 is disposed on the first surface 11 of the printed circuit board 1. The printed circuit board 1 further includes a first line 13, and the first pad 12 is connected to the first line 13. A surface that is of the flexible printed circuit 2 and that faces the printed circuit board 1 is a second surface 21, and a second pad 22 is disposed on the second surface 21 of the flexible printed circuit 2. The flexible printed circuit 2 further includes a second line 23, and the second pad is connected to the second line 23. The first pad 12 is connected the second pad 22 through soldering, so that the first line 13 is connected to the second line 23, thereby implementing a physical connection and a signal connection between the printed circuit board 1 and the flexible printed circuit 2. A support structure 5 is disposed between the printed circuit board 1 and the flexible printed circuit 2, and the support structure 5 provides support between the printed circuit board 1 and the flexible printed circuit 2, so that a preset gap 6 exists between the printed circuit board 1 and the flexible printed circuit 2. The preset gap 6 serves as a gas outlet channel. When the first pad 12 and the second pad 22 are soldered, gas generated during a soldering process is discharged through the gas outlet channel between the printed circuit board 1 and the flexible printed circuit 2, so that solder is not displaced, thereby improving reliability of soldering between the first pad 12 and the second pad 22, and improving efficiency and reliability of signal transmission between the printed circuit board 1 and the flexible printed circuit 2.

In a specific embodiment, a width of the preset gap 6 may range from 10 micrometers to 500 micrometers, for example, may be 15 micrometers, 50 micrometers, 60 micrometers, 80 micrometers, 100 micrometers, 120 micrometers, 150 micrometers, 160 micrometers, 200 micrometers, 230 micrometers, 250 micrometers, 300 micrometers, 350 micrometers, 380 micrometers, 400 micrometers, 420 micrometers, 450 micrometers, or 490 micrometers. The width of the preset gap 6 is at least 10 micrometers, so that a requirement for a manufacturing process is low. In addition, the width is adequate to allow the gas generated during the soldering process to be discharged through the preset gap 6, thereby preventing residual gas from displacing the solder. In addition, the width of the preset gap 6 does not exceed 500 micrometers, so that solder between pads is thin, and has high strength, and a connection between the first pad 12 and the second pad 22 is reliable. In conclusion, the gap needs to be set to both allow for adequate discharge of the gas and ensure the reliable connection between the first pad 12 and the second pad 22.

FIG. 14 is a diagram of a partial cross-sectional view of another structure of an electronic assembly according to an embodiment of this application. As shown in FIG. 13 and FIG. 14, when the support structure 5 is formed, the support structure 5 at a position between the printed circuit board 1 and the flexible printed circuit 2 may be an independent integrated structure, and the support structure 5 is fastened to the printed circuit board 1 or the flexible printed circuit 2. Specifically, as shown in FIG. 13, in a possible implementation, the support structure 5 is fastened to the first surface 11 of the printed circuit board 1, and during soldering, one end that is of the support structure 5 and that is away from the printed circuit board 1 abuts against the second surface 21 of the flexible printed circuit 2. It may be understood that the support structure 5 includes two opposite ends, one end is fastened to the printed circuit board 1, and the other end abuts against the flexible printed circuit 2. In another possible implementation, as shown in FIG. 14, the support structure 5 is fastened to the second surface 21 of the flexible printed circuit 2, and during soldering, one end that is of the support structure 5 and that is away from the flexible printed circuit 2 abuts against the first surface 11 of the printed circuit board 1. It may be understood that the support structure 5 includes two opposite ends, one end is fastened to the flexible printed circuit 2, and the other end abuts against the printed circuit board 1. In the foregoing two implementations, a requirement for an abutting position of the support structure 5 is low, and a requirement for precision of position manufacturing and design of the support structure 5 is low. In addition, the support structure 5 is manufactured only on one side, which can simplify a manufacturing process.

FIG. 15 is a diagram of a partial cross-sectional view of another structure of an electronic assembly according to an embodiment of this application. As shown in FIG. 15, in another possible embodiment, the support structure 5 at a position between the printed circuit board 1 and the flexible printed circuit 2 may be a split structure, and includes two parts. The two parts are specifically a first support structure 51 and a second support structure 52. The first support structure 51 is fastened to the first surface 11 of the printed circuit board 1, and the second support structure 52 is fastened to the second surface 21 of the flexible printed circuit 2. When the printed circuit board 1 and the flexible printed circuit 2 are soldered, the printed circuit board 1 and the flexible printed circuit 2 are opposite to each other, and the first support structure 51 and the second support structure 52 abut against each other to form the support structure 5, so that the printed circuit board 1 and the flexible printed circuit 2 are supported to form the preset gap 6, and the preset gap 6 serves as a gas outlet channel. In this solution, the support structure 5 includes two parts. Therefore, when a support structure 5 of a specific height, especially a high support structure 5, is formed, the first support structure 51 and the second support structure 52 may be separately manufactured to be short, thereby simplifying a manufacturing process of the support structure 5.

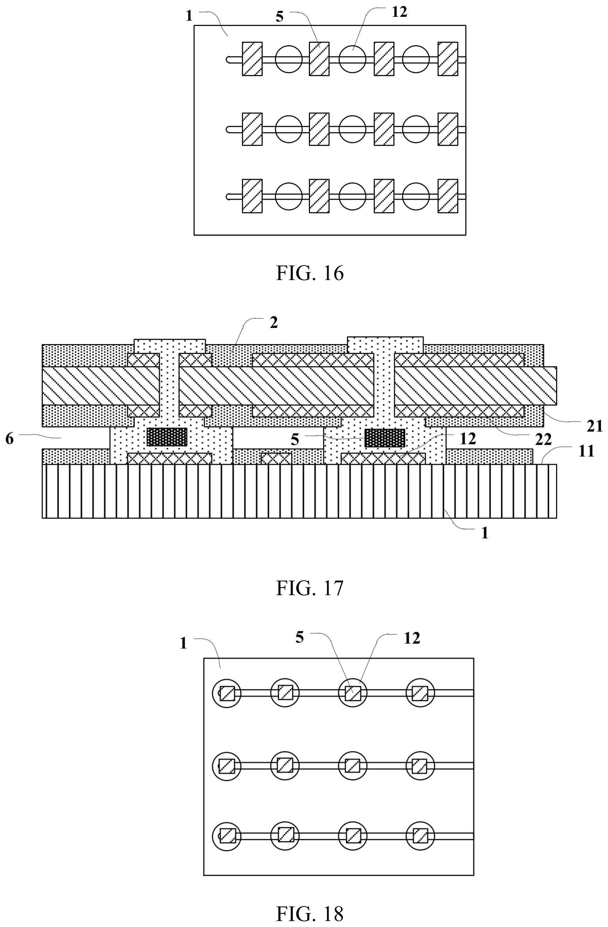

FIG. 16 is a diagram of a partial cross-sectional view of another structure of an electronic assembly according to an embodiment of this application. As shown in FIG. 16, in specific application, the printed circuit board 1 may include a plurality of first pads 12. Correspondingly, a plurality of second pads 22 may be disposed on the flexible printed circuit 2, and the first pads are soldered to the second pads, to form a plurality of solder joints between the printed circuit board 1 and the flexible printed circuit 2. A plurality of support structures 5 may be disposed between the printed circuit board 1 and the flexible printed circuit 2. When the plurality of support structures 5 are disposed, there may be a plurality of quantities and arrangement manners of the support structures 5. In a possible embodiment, the support structures 5 are evenly distributed between the printed circuit board 1 and the flexible printed circuit 2, to form a uniform gas outlet channel.

Alternatively, in another possible embodiment, positions of the support structures may be designed based on actual distribution of the solder joints between the printed circuit board 1 and the flexible printed circuit 2. For example, the support structures 5 are disposed on two sides of the first pad 12 in a specific direction. That is, the support structures 5 are disposed on two sides of the solder joint in a specific direction. The gas outlet channel is formed in a targeted manner on a periphery of the solder joint between the printed circuit board 1 and the flexible printed circuit 2, to discharge gas generated by the solder joint.

In still another possible embodiment, the support structures 5 may alternatively be arranged in a set shape like a ring, to provide support between the printed circuit board 1 and the flexible printed circuit 2, and the like.

A specific material for forming the support structure 5 is not limited either. For example, the support structure 5 may be at least one of a copper layer (copper line or copper pour), a solder mask layer, a silkscreen layer, a coverlay, and an adhesive film. Materials of different support structures 5 may be the same or may be different, and may be specifically selected and designed based on a specific form of a product. This is not limited in this application. Specifically, the support structure 5 formed on the surface of the printed circuit board 1, a material required for manufacturing the printed circuit board 1 is preferentially selected, and for the support structure 5 formed on the surface of the flexible printed circuit 2, a material required for manufacturing the flexible printed circuit 2 is preferentially selected, to simplify a manufacturing process of the support structure 5.

FIG. 17 is a diagram of a partial cross-sectional view of a structure of an electronic assembly according to an embodiment of this application. As shown in FIG. 17, in another possible embodiment, the support structure 5 may alternatively be disposed in solder between the first pad 12 and the second pad 22. Specifically, the first pad 12 is connected to the second pad 22 through soldering by using the solder, and the support structure 5 is disposed in the solder, so that the preset gap 6 may be formed. In this solution, the support structure 5 does not need to be formed when the printed circuit board 1 or the flexible printed circuit 2 is manufactured. Instead, the support structure 5 is added during soldering. This simplifies a manufacturing of the printed circuit board 1 and a manufacturing process of the flexible printed circuit 2. In addition, the support structure 5 is directly disposed in a solder joint, which is more targeted. It should be noted that disposing the support structure 5 in the solder does not mean that the solder completely covers the support structure 5. It may be understood that the support structure 5 is fastened between the printed circuit board 1 and the flexible printed circuit 2 by using the solder.

A shape of the support structure 5 is not limited in this embodiment. The support structure 5 may be in the shape of a spacer, a sphere, or the like, or may be of an irregular shape, which may be specifically set based on an actual requirement.

In addition, in an optional implementation, the support structure 5 may be a metal support structure. That is, the entire support structure 5 is made of a metal material. The metal support structure has high strength and good support effect. In another optional implementation, the support structure 5 may have a metal layer only on a surface, and have a non-metal inner core inside. Costs of the support structure 5 in this solution are low. In conclusion, the support structure 5 needs to be soldered by using a soldering process, and at least an outer surface of the support structure 5 is made of a metal material.

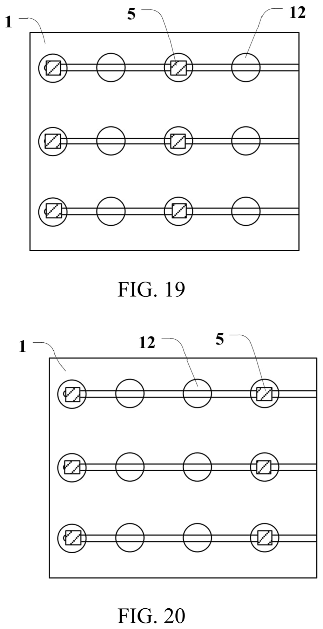

Specifically, the printed circuit board 1 includes a plurality of first pads 12. Correspondingly, a plurality of second pads 22 may also be disposed on the flexible printed circuit 2. Each soldered group of the first pad 12 and the second pad 22 forms one solder joint, and a plurality of solder joints are formed between the printed circuit board 1 and the flexible printed circuit 2. FIG. 18 to FIG. 20 are diagrams of a partial cross-sectional view of a structure of an electronic assembly according to different embodiments of this application, and are layout diagrams of the support structure 5 disposed in a solder joint. As shown in FIG. 18, in a possible implementation, the support structure 5 may be disposed in each solder joint, or in other words, the support structure 5 may be disposed between each first pad 12 and the corresponding second pad 22. Alternatively, as shown in FIG. 19, in another possible embodiment, one support structure 5 may be disposed in every other solder joint of the plurality of solder joints. Alternatively, one support structure 5 is disposed every other first pad 12. Alternatively, as shown in FIG. 20, one support structure 5 may be disposed at intervals of two or more solder joints in the plurality of solder joints, to reduce disposition of the support structure 5 and simplify the soldering process.

A quantity of support structures 5 disposed in one solder joint may also be selected based on a requirement. To simplify the soldering process and improve the support effect, only one support structure 5 may be disposed in one solder joint.

It is clear that a person skilled in the art can make various modifications and variations to this application without departing from the scope of this application. In this way, this application is intended to cover these modifications and variations of this application provided that they fall within the scope of the claims of this application and equivalent technologies thereof.

## Claims

1. An electronic assembly, comprising a printed circuit board and a flexible printed circuit, wherein a first pad is disposed on a first surface of the printed circuit board, a second pad is disposed on a second surface of the flexible printed circuit, and the first pad is connected to the second pad through soldering; and
a support structure is disposed between the printed circuit board and the flexible printed circuit, so that a preset gap exists between the printed circuit board and the flexible printed circuit.

2. The electronic assembly according to claim 1, wherein the support structure is fastened to the first surface of the printed circuit board, and abuts against the second surface of the flexible printed circuit; or the support structure is fastened to the second surface of the flexible printed circuit, and abuts against the first surface of the printed circuit board.

3. The electronic assembly according to claim 1, wherein the support structure comprises a first support structure and a second support structure, the first support structure is fastened to the first surface of the printed circuit board, the second support structure is fastened to the second surface of the flexible printed circuit, and the first support structure and the second support structure abut against each other.

4. The electronic assembly according to any one of claims 1 to 3, wherein the support structure is evenly distributed between the printed circuit board and the flexible printed circuit.

5. The electronic assembly according to any one of claims 1 to 4, wherein the support structure is disposed on at least two sides of the first pad.

6. The electronic assembly according to any one of claims 1 to 4, wherein the support structure comprises at least one of a copper layer, a solder mask layer, a silkscreen layer, a coverlay, and an adhesive film.

7. The electronic assembly according to claim 1, wherein the support structure is disposed in solder between the first pad and the second pad.

8. The electronic assembly according to claim 7, wherein the support structure is a spacer or a sphere.

9. The electronic assembly according to claim 7 or 8, wherein the support structure is a metal support structure, or the support structure has a metal layer on a surface.

10. An electronic device, comprising a housing and the electronic assembly according to any one of claims 1 to 9, wherein the electronic assembly is disposed in the housing.
